# FASCICULE DE BREVET EUROPEEN

(11) **EP 3 576 165 B1**
(45) Date de publication et mention de la délivrance du brevet: **16.12.2020**
(21) Numéro de dépôt: 19176768.0
(22) Date de dépôt: 27.05.2019
(51) Int. Cl.: H01L 33/04, H01L 33/00, H01L 33/02

(54) **PROCEDE DE FABRICATION D'UNE DIODE ELECTRO- LUMINESCENTE DE TYPE GAN**
HERSTELLUNGSVERFAHREN EINER ELEKTROLUMINESZENZDIODE VOM TYP GAN
METHOD FOR MANUFACTURING A GAN TYPE LIGHT-EMITTING DIODE

(30) Priorité: 29.05.2018 FR 1854602
(43) Date de publication de la demande: 04.12.2019
(73) Titulaire: Commissariat à l'Énergie Atomique et aux Énergies Alternatives, 75015 Paris (FR)
(72) Inventeur: CHARLES, Matthew, 38054 GRENOBLE Cedex 09 (FR)
(74) Mandataire: Guérin, Jean-Philippe

(56) Documents cités:
- WO-A1-02/093658
- US-A1- 2012 015 502

## Description

L'invention concerne les diodes électroluminescentes de type GaN et en particulier les procédés de fabrication de telles diodes électroluminescentes.

La fabrication de diodes électroluminescentes incluant des couches d'alliage de GaN suppose le dopage de certaines de ces couches avec des dopants de type P. Un dopage de type P est relativement délicat à réaliser car les niveaux d'accepteur sont profonds. Ainsi, la proportion d'ionisation du dopant de type P à température ambiante reste relativement basse. Du fait de son énergie d'ionisation relativement faible, on utilise fréquemment du Magnésium comme dopant de type P pour les couches d'alliage de GaN. La solubilité du Magnésium dans des alliages de GaN reste cependant faible. Ainsi, lors d'une superposition d'une couche d'alliage de GaN dopée P et d'une couche de GaN sans dopage intentionnel de magnésium, on retrouve du Magnésium dans cette dernière couche de GaN, dite NID. La décroissance de la concentration de magnésium dans la couche d'alliage de GaN NID depuis son interface avec la couche d'alliage pGaN est relativement lente, une concentration de Magnésium non négligeable pouvant être constatée sur une épaisseur de l'ordre de 100nm de la couche d'alliage GaN nid.

Pour la fabrication de diodes électroluminescentes de type GaN, on réalise un empilement de couches, la dernière couche fonctionnelle déposée lors du procédé de fabrication étant généralement une couche d'alliage pGaN utilisant le Magnésium comme dopant. Une électrode de contact doit alors être formée sur la face supérieure de cet empilement. Pour cette structure, la décroissance de la concentration de magnésium n'est pas gênante. Cependant, en vue d'améliorer la résistance de contact sur la face supérieure de l'empilement, un procédé décrit dans la publication 'µLEDs with tunnel junction by MBE and MOCVD+MBE', publié en 2015 dans Applied Physics Letters, 107, 051107, utilise une couche d'alliage nGaN sur la couche d'alliage pGaN pour former une jonction tunnel. US 2012/015502 A1 et WO 02/093658 A1 décrivent des procédés connus de fabrication de diodes électroluminescentes avec des jonctions tunnels.

Lorsque les couches d'alliage nGaN et pGaN sont formées par des étapes d'épitaxie par MOCVD, la couche d'alliage nGaN présente une concentration non négligeable en Magnésium. La jonction tunnel devient alors inopérante.

L'invention vise à résoudre un ou plusieurs de ces inconvénients. L'invention porte ainsi sur un procédé de fabrication d'une diode électroluminescente, tel que défini dans les revendications annexées.

L'invention porte également sur les variantes des revendications dépendantes. L'homme du métier comprendra que chacune des caractéristiques des variantes de la description ou des revendications dépendantes peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe schématique d'une structure multicouche réalisée par un procédé de fabrication selon l'invention ;
- les figures 2 à 6 sont des vues en coupe schématiques de différentes étapes d'un procédé de fabrication selon un mode de réalisation de l'invention ;
- la figure 7 est un diagramme comparatif de la concentration en Magnésium dans l'épaisseur d'une structure multicouche, en fonction de son procédé de fabrication ;
- la figure 8 est un diagramme comparatif de la concentration en Magnésium dans l'épaisseur d'une structure multicouche, en fonction de variantes de procédés de fabrication selon un autre aspect de l'invention.

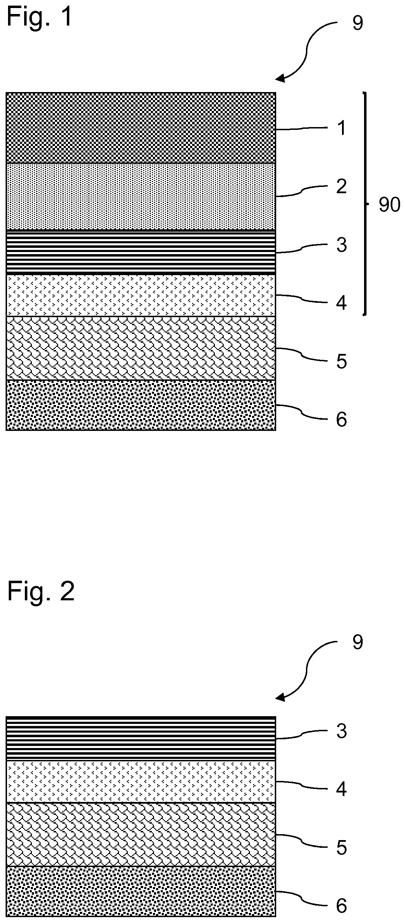

La figure 1 est une vue en coupe transversale schématique d'une structure multicouche 9, réalisée par un procédé de fabrication selon l'invention. La structure multicouche 9 comprend une diode électroluminescente 90, formée sur une couche tampon 5. La couche tampon 5 est fixée sur un substrat 6.

La diode électroluminescente 90 inclut ici :
- une couche 4 en AlGaN dopé N, formée sur la couche tampon 5 ;
- une couche 3 de puits quantiques multiples, formée sur la couche 4 ;
- une couche 2 en AlGaN dopé P, formée sur la couche 3 ;
- une couche 1 en AlGaN dopé N, formée sur la couche 2.

L'association des couches 1 et 2 forme une jonction tunnel. Une association appropriée de matériaux des couches 1 et 2 pour former une jonction tunnel est connue en soi de l'homme du métier. La face supérieure de la couche 1 est destinée à former une interface de contact pour une électrode non illustrée. La diode électroluminescente 9 est de type GaN, à émission dans le spectre visible ou ultraviolet.

Le substrat 6 présente une structure connue en soi. Le substrat 6 peut être un isolant ou un semi-conducteur de type silicium intrinsèque ou dopé, ou du SiC du saphir ou même de l'AlN ou du GaN. Le substrat 6 peut typiquement présenter une épaisseur de l'ordre de 350 µm à 1,5mm et un diamètre de l'ordre de 10mm à 300mm.

Une couche d'adaptation non illustrée peut être interposée entre le substrat 6 et la couche tampon 5. La couche tampon 5 est par exemple en GaN non intentionnellement dopé.

La couche d'AlGaN 4 présente un dopage N, avec par exemple une concentration de silicium ou germanium typiquement comprise entre 1*10¹⁷ cm⁻³ et 1*10¹⁹ cm⁻³.

La couche 3 de puits quantiques multiples présente une structure connue en soi, avec par exemple plusieurs alternances d'un empilement de couches de GaN et de InGaN, ou des couches AlGaN/GaN ou même AlxGa₍₁₋ₓ₎N/Al_{y}Ga_{(1-y)}N où x ≠ y.

La couche 2 en AlGaN dopé P peut par exemple présenter de façon connue en soi une épaisseur typiquement comprise entre 50nm et 400nm et une concentration chimique en Magnésium typiquement comprise entre 1 * 10¹⁸ cm⁻³ et 1 * 10²⁰ cm⁻³. Le dopage dopé P est ici obtenu par ionisation de Magnésium introduit dans l'AlGaN de la couche 2. La couche 2 peut également être réalisée en tout autre alliage de GaN.

La couche 1 en AlGaN dopé N peut par exemple présenter de façon connue en soi une épaisseur typiquement comprise entre 20 et 200nm et une concentration en dopant N typiquement comprise entre 1 * 10¹⁸ cm⁻³ et 1 * 10²⁰ cm⁻³. La concentration du dopant peut être plus importante à côté de la jonction, et moins importante vers la surface. La couche 2 peut également être réalisée en tout autre alliage de GaN, par exemple en un alliage d'InGaN.

On doit éviter que du magnésium que l'on a eu du mal à intégrer dans la couche 2 ne se retrouve dans la couche 1, ce magnésium rendant alors difficile la formation d'une jonction tunnel.

Les figures 2 à 6 sont des vues en coupe schématiques illustrant différentes étapes d'un procédé de fabrication selon un mode de réalisation de l'invention.

À la figure 2, on fournit une structure multicouche 9 en formation, munie d'un substrat 6 surmonté d'une couche tampon 5, d'une couche en AlGaN 4 et d'une couche 3 de puits quantiques multiples, tels que décrits précédemment et pouvant être obtenus par des procédés connus en soi.

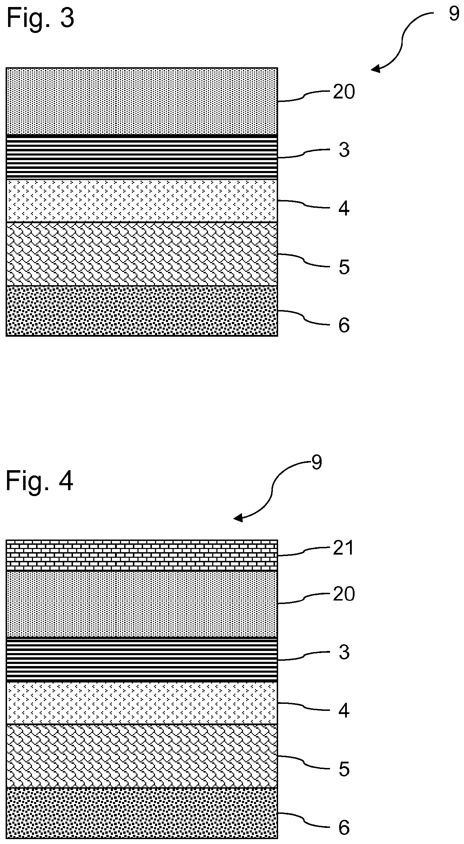

À la figure 3, on procède au dépôt d'une couche de pAlGaN 20, selon des paramètres connus en soi. Par exemple, en plaçant la structure 9 dans une enceinte de croissance épitaxiale en phase vapeur (non illustrée), on crée une atmosphère gazeuse dans l'enceinte, avec un mélange incluant des précurseurs du Gallium (par exemple TMGa), de l'Aluminium (par exemple TMAI), du Magnésium (par exemple Cp₂Mg), de l'ammoniac, de l'hydrogène et de l'azote. La pression partielle d'ammoniac dans le mélange est typiquement comprise entre 2000 et 8000 Pa pour cette étape. La concentration d'un gaz dans l'atmosphère à l'intérieur de l'enceinte pourra être exprimée comme le rapport de la pression partielle de ce gaz sur la pression totale dans l'enceinte. La pression partielle de magnésium est fixée à un niveau permettant d'obtenir la concentration souhaitée en magnésium pour la couche 2. On peut par exemple viser une concentration chimique moyenne en magnésium au moins égale à de 1 * 10¹⁹ cm⁻³, voire au moins égale à de 1 * 10²⁰ cm⁻³ dans la couche 2. La température dans l'enceinte pour réaliser la croissance épitaxiale de la couche 20 est par exemple de 1000° C. Le dépôt de la couche de pAlGaN 20 peut avantageusement être réalisé avec une épaisseur comprise entre 50 et 400 nm.

La figure 4 illustre une autre étape du procédé de fabrication selon le mode de réalisation. En maintenant la structure 9 dans l'enceinte de croissance épitaxiale en phase vapeur, on modifie l'atmosphère gazeuse dans l'enceinte en supprimant l'alimentation en magnésium de l'atmosphère de l'enceinte. L'enceinte est ainsi maintenue dans une atmosphère gazeuse de croissance épitaxiale avec un mélange incluant du Gallium, de l'ammoniac, du dihydrogène et de l'azote. On procède ainsi au dépôt d'une couche 21 de GaN sur la couche 20 de pAlGaN, avec des conditions de formation d'une couche GaN de type non intentionnellement dopé.

La pression partielle d'ammoniac dans le mélange pour le dépôt de la couche 21 est typiquement comprise entre 4000 et 15000 Pa pour cette étape. La température dans l'enceinte pour réaliser la croissance épitaxiale de la couche 21 est par exemple de 1050° C. Le dépôt de la couche de GaN 21 peut avantageusement être réalisé sur une épaisseur comprise entre 50 et 200 nm. Du fait de l'effet mémoire du magnésium utilisé lors du dépôt de la couche 20, la couche 21 inclut également du magnésium. La concentration en magnésium décroît dans la couche 21 au fur et à mesure qu'on s'éloigne de son interface avec la couche 20.

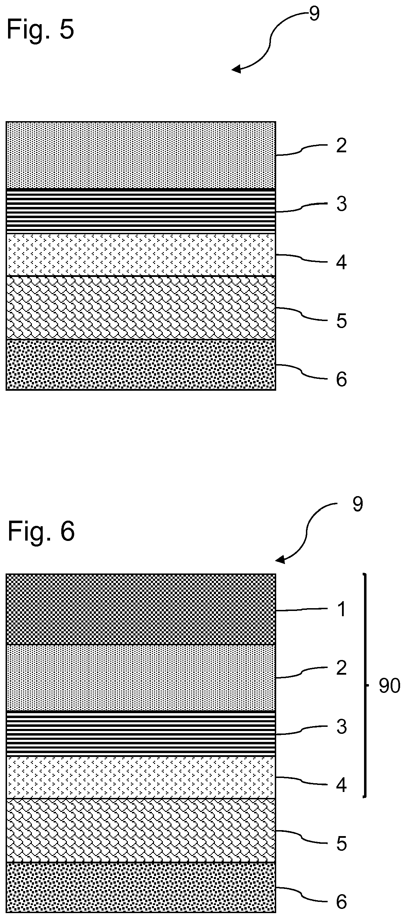

Pour obtenir la configuration illustrée à la figure 5, on a maintenu la structure multicouches 9 dans l'enceinte de croissance épitaxiale. On place alors l'atmosphère à l'intérieur de l'enceinte dans des conditions de retrait de la couche 21 et/ou de la partie supérieure de la couche 20.

Selon une première solution, l'atmosphère à l'intérieur de l'enceinte pour cette étape de retrait présente ici une concentration Cg1 en ammoniac, au plus égale au tiers de la concentration Cd1 en ammoniac de l'atmosphère durant le dépôt de la couche 20. Avantageusement, la concentration Cg1 est au plus égale à 10 % de la concentration Cd1. L'étape de retrait comprend ici le retrait de l'intégralité de la couche 21. Le retrait est réalisé par un mécanisme de désorption de la couche 21.

Avantageusement, la concentration en ammoniac Cg1 dans l'atmosphère durant cette étape de retrait est non nulle, afin de stabiliser le processus de gravure/retrait. La concentration en ammoniac Cg1 dans l'atmosphère à l'intérieur de l'enceinte pour cette étape de retrait peut par exemple être au moins égale à 4 % de la concentration Cd1, et peut par exemple être égale à 5% de la concentration Cd1.

Le retrait de la partie supérieure de la couche précurseur est avantageusement mis en œuvre sur une épaisseur au moins égale à 20 nm, afin de favoriser le front de décroissance de la concentration en magnésium.

L'atmosphère utilisée pour mettre en œuvre cette étape de retrait comprend également du dihydrogène et ce retrait est mis en œuvre à une température de 1050°C. Avec de telles conditions de retrait, une vitesse de gravure de 2 µm/h a été obtenue pour la couche 21 avec une concentration en ammoniac Cg1 de 5% de la concentration Cd1 ou une pression partielle d'ammoniac comprise entre 200 et 300 Pa.

Selon une seconde solution, l'atmosphère à l'intérieur de l'enceinte pour cette étape de retrait présente ici une concentration en ammoniac nulle. L'étape de retrait comprend ici le retrait de l'intégralité de la couche 21. Le retrait est réalisé par un mécanisme de désorption de la couche 21.

Le retrait de la partie supérieure de la couche précurseur est avantageusement mis en œuvre sur une épaisseur au moins égale à 20 nm, afin de favoriser le front de décroissance de la concentration en magnésium.

L'atmosphère utilisée pour mettre en œuvre cette étape de retrait comprend du dihydrogène et ce retrait est mis en œuvre à une température de 1050°C. Avec de telles conditions de retrait, une vitesse de gravure de 12 µm/h a été obtenue pour la couche 21.

La couche 20 est soit utilisée comme couche d'arrêt suite à la gravure de la couche 21 (la couche 20 étant en AlGaN alors que la couche 21 est en GaN), soit subit une gravure supplémentaire en maintenant les conditions de retrait. On obtient alors la couche 2 à partir de la couche 20, comme illustré à la figure 5. Lorsque la couche 21 est en GaN alors que la couche 20 est en AlGaN, cette couche 20 forme naturellement une couche d'arrêt pour les conditions de gravure de la couche 21 dans l'enceinte d'épitaxie. L'utilisation de la couche 20 comme couche d'arrêt permet de limiter les dispersions du procédé de fabrication, en garantissant un bon contrôle de l'étape de gravure de la couche 21. On peut cependant également envisager de réaliser la couche 21 en AlGaN. Nous avons déjà noté que la couche 20 peut être également du GaN, sans former une couche d'arrêt.

À la figure 6, on a procédé à un dépôt d'une couche 1 sur la couche 2. Dans l'exemple illustré, on a procédé à un dépôt par épitaxie de la couche 1 d'AlGaN dopé N sur la couche 2. La couche 1 peut faire l'objet d'une étape de mécanopolissage postérieurement à son dépôt.

Des étapes additionnelles d'un procédé de fabrication d'une diode électroluminescente ne seront pas davantage détaillées (formation d'une électrode sur la couche 1, sous forme de motifs d'électrodes en pixels par exemple, ou formation d'un contact de polarisation de la couche 4 par exemple), ces étapes étant connues en soi de l'homme du métier.

En variante, on peut également envisager de déposer une couche de InGaN entre la couche 2 et la couche 1 (sur une épaisseur par exemple comprise entre 2 et 5nm), en vue d'améliorer la performance de la jonction tunnel.

On peut également envisager de varier la concentration d'Aluminium dans l'épaisseur de la couche 1 ou de la couche 2, en vue de favoriser un dopage avec polarisation.

Lors d'une croissance de la couche 20 par épitaxie, le magnésium peut être passivé par de l'hydrogène provenant de l'ammoniac. La présence de la couche 1 peut rendre un retrait de l'hydrogène compliqué. Un recuit de dépassivation peut être effectué après le retrait de la couche sacrificielle 21. De l'azote est alors utilisé comme gaz porteur, par exemple avec de l'hydrazine (ou toute autre molécule qui ne génère pas d'hydrogène) comme précurseur d'azote, pour éviter l'incorporation d'hydrogène, et la passivation du magnésium.

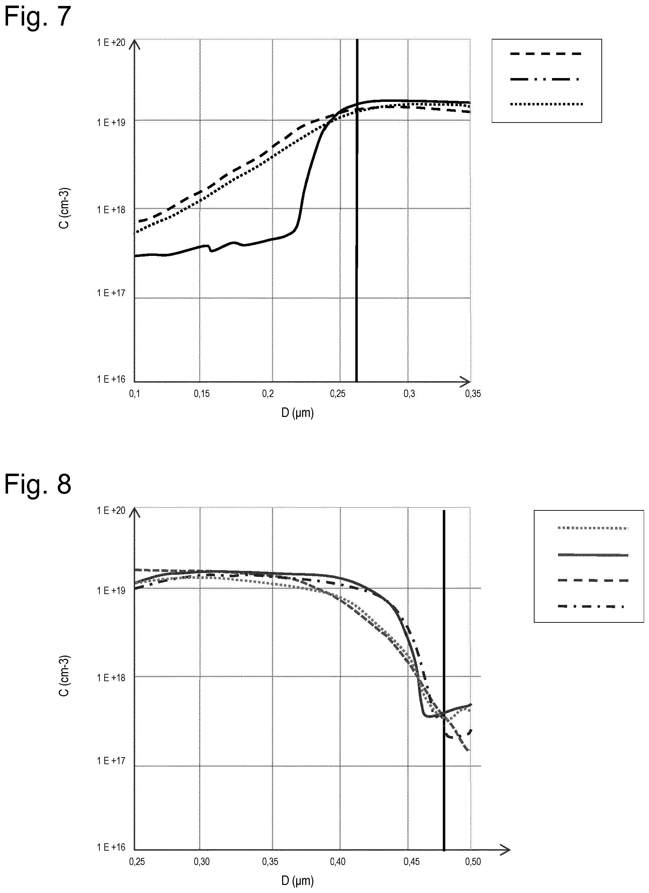

La figure 7 est un diagramme comparatif de la concentration C en Magnésium en fonction de la position D dans la profondeur d'une structure multicouche, et en fonction de son procédé de fabrication. Une profondeur D nulle correspond à la face supérieure de la couche 1 de la structure 9. Une profondeur de 0,27µm correspond à l'interface entre la couche 1 et la couche 2.

La courbe en trait discontinu correspond à une structure réalisée selon un procédé de l'état de la technique, dans lequel une couche de GaN 1 est déposée par épitaxie immédiatement après le dépôt par épitaxie d'une couche de pGaN 2. La courbe en pointillés correspond à une structure réalisée selon un procédé de l'état de la technique, dans lequel un recuit de 5 minutes est mis en œuvre entre le dépôt d'une couche de pGaN 2 et le dépôt d'une couche de GaN 1, en retirant le gallium (TMGa) de l'atmosphère de l'enceinte pendant ce recuit. La courbe en trait continu correspond à une structure 1 obtenue avec un procédé de fabrication selon le mode de réalisation de l'invention.

On constate d'une part qu'une épaisseur de la couche de GaN 1 d'au moins 100 nm s'avère nécessaire pour un procédé selon l'état de la technique, pour réduire la concentration en Magnésium d'une décade par rapport à son interface avec la couche 2. Même avec un procédé selon l'état de la technique mettant en œuvre une étape de recuit, une telle épaisseur de la couche de GaN 1 s'avère nécessaire pour réduire la concentration en magnésium d'une décade par rapport à l'interface avec la couche 2.

A contrario, on constate que la concentration en magnésium baisse d'une décade avec une épaisseur d'une couche de GaN 1 d'environ 30 nm pour une structure 9 réalisée selon le mode de réalisation de l'invention.

Le procédé de fabrication selon l'invention permet ainsi d'accroître la pente de décroissance de la concentration en magnésium dans la couche d'AlGaN 1 formée sur la couche 2. Selon l'invention, la pente de décroissance de la concentration en magnésium dans la couche d'AlGaN 1 formée sur la couche 2 est donc particulièrement abrupte. Ainsi, la formation d'une électrode conductrice sur la couche d'AlGaN 1 est facilitée, sans altérer les propriétés de la couche d'AlGaN 2. Un tel résultat est par ailleurs obtenu sans polluer l'interface entre les couches 1 et 2, du fait du maintien de la structure 9 dans l'enceinte d'épitaxie. Le procédé de fabrication est en outre relativement rapide, du fait du maintien de la structure 9 dans l'enceinte d'épitaxie durant ces différentes étapes du procédé.

Ceci peut s'avérer particulièrement avantageux pour une diode électroluminescente dont le spectre d'émission se situe essentiellement dans le visible, mais peut également s'appliquer à une diode électroluminescente dont le spectre d'émission se situe essentiellement dans l'ultraviolet.

Afin d'accroître encore la vitesse de décroissance de la concentration en magnésium au-dessus de la couche 2, le procédé met avantageusement en œuvre une alternance d'étapes de :
- retrait partiel de la couche 21 ;
- croissance par épitaxie d'une couche de GaN avec des conditions de formation d'une couche de type non intentionnellement dopé.

On peut par exemple envisager de mettre en œuvre au moins une dizaine d'alternances de telles étapes.

L'étape de retrait de la couche 21 est ici avantageusement mise en œuvre en maintenant une certaine concentration en ammoniac dans l'atmosphère de l'enceinte. Un tel retrait permet à la fois d'obtenir une vitesse de retrait suffisamment élevée pour mettre en œuvre un processus industriel rapidement, et suffisamment faible pour bien contrôler le processus de retrait. Par ailleurs, un tel retrait peut être réalisé dans les mêmes conditions de température que le dépôt de la couche 20, ce qui permet d'éviter de nécessiter un refroidissement préalable de la structure.

On peut cependant également envisager de mettre en œuvre un retrait avec d'autres atmosphères dans l'enceinte, à l'issue du dépôt par épitaxie de la couche 20. On peut par exemple introduire du Cl₂ ou du HCl dans l'enceinte pour mettre en œuvre l'étape de retrait. L'utilisation de Cl₂ a comme intérêt particulier une gravure à plus basse température, entre 500°C et 800°C, qui est intéressante pour les LEDs émettant en lumière visible, avec des puits quantiques contenant de l'indium, qui ne seraient pas stables si on utilisait un budget thermique à 1050°C.

Selon un autre aspect indépendant de l'invention, l'étape de formation de la couche 20 (précurseur de la couche 2) peut être mise en œuvre de façon à ce que la concentration en magnésium dans le fond de cette couche 20 soit très abrupte. Avec un tel front abrupt, on peut utiliser une couche 2 encore moins épaisse.

À cet effet, l'étape de dépôt de la couche précurseur 20 en pAlGaN détaillée en référence à la figure 3 peut être mise en œuvre de la façon suivante. Lorsque la structure multicouches 9 est disposée dans l'enceinte de croissance épitaxiale en phase vapeur, la surface de la couche est saturée préalablement en magnésium, avant que les conditions de croissance par épitaxie de la couche précurseur en pAlGaN ne soient établies. L'ajout du précurseur du magnésium dans l'enceinte pour atteindre la saturation en magnésium de la surface peut avantageusement être réalisé pendant une durée au moins égale à 10 secondes. Une fois la surface saturée en magnésium, on initie le dépôt de la couche de pAlGaN 20 avec des conditions de croissance par épitaxie telles que décrites en référence à la figure 3. La saturation est faite par l'envoi du précurseur de magnésium sans envoyer le précurseur du gallium, ou avec très peu du précurseur du gallium.

La figure 8 illustre un diagramme comparatif de la concentration en magnésium dans l'épaisseur de la couche de pAlGaN 2 en fonction de la durée de maintien de l'atmosphère en magnésium, préalablement au dépôt par épitaxie de la couche pAlGaN. Le trait vertical correspond au fond de la couche 2. La courbe en trait discontinu correspond à un procédé de fabrication dépourvu de maintien de l'atmosphère de l'enceinte d'épitaxie avec du magnésium avant le dépôt par épitaxie de la couche de pAlGaN. La courbe en pointillés correspond à un procédé de fabrication dans lequel l'atmosphère de l'enceinte d'épitaxie est maintenue avec du magnésium pendant une durée de 30 secondes avant le dépôt par épitaxie de la couche de pAlGaN. La courbe en tiret-point correspond à un procédé de fabrication dans lequel l'atmosphère de l'enceinte d'épitaxie est maintenue avec du magnésium pendant une durée de 90 secondes avant le dépôt par épitaxie de la couche de pAlGaN. La courbe en trait continu correspond à un procédé de fabrication dans lequel l'atmosphère de l'enceinte d'épitaxie est maintenue avec du magnésium pendant une durée de 120 secondes avant le dépôt par épitaxie de la couche pAlGaN. On constate que plus on maintient longtemps l'atmosphère avec du Magnésium avant de rentrer dans les conditions d'épitaxie, plus le front de concentration en Magnésium au fond de la couche 2 est abrupt.

L'invention s'avère particulièrement avantageuse pour une structure 9 destinée à former des matrices de pixels de diodes électroluminescentes car le procédé de fabrication de ces composants impose des contraintes sur le choix de métallisation pour les contacts, et donc la jonction tunnel permet l'utilisation de différents métaux tout en gardant un bon contact.

## Revendications

1. Procédé de fabrication d'une diode électroluminescente (9), comprenant la succession des étapes suivantes en maintenant un substrat (6) dans une enceinte de croissance épitaxiale en phase vapeur :
- avec une atmosphère dans l'enceinte présentant une première concentration non nulle en ammoniac, dépôt par épitaxie d'une première couche (20) d'alliage de GaN dopée P avec du Magnésium;
- dépôt par épitaxie, sur la première couche (20), d'une couche (21) sacrificielle d'alliage de GaN dans une atmosphère dans l'enceinte non alimentée en Magnésium ;
- placement de l'atmosphère à l'intérieur de l'enceinte avec une deuxième concentration en ammoniac au plus égale au tiers de la première concentration de façon à retirer la couche sacrificielle (21) ; puis
- dépôt par épitaxie d'une deuxième couche d'alliage de GaN (1) à dopage de type N de façon à former une jonction tunnel avec la première couche (2).

2. Procédé de fabrication selon la revendication 1, dans lequel ledit alliage de la première couche (2) déposée est de l'AlGaN.

3. Procédé de fabrication selon la revendication 2, dans lequel la première couche (2) présente un gradient de concentration d'Aluminium dans son épaisseur.

4. Procédé de fabrication selon l'une quelconque des revendications précédentes, dans lequel l'épaisseur de la première couche (2) déposée est comprise entre 50 et 400nm.

5. Procédé de fabrication selon l'une quelconque des revendications précédentes, dans lequel l'alliage de la couche sacrificielle (21) est différent de l'alliage de la première couche (20).

6. Procédé de fabrication selon l'une quelconque des revendications précédentes, dans lequel ledit alliage de la deuxième couche (1) déposée est de l'AlGaN.

7. Procédé de fabrication selon l'une quelconque des revendications précédentes, dans lequel ledit substrat (6) maintenu dans l'enceinte de croissance épitaxiale est surmonté d'une couche à puits quantiques multiples (3) et dans lequel la première couche (2) est déposée sur la couche à puits quantiques multiples (3).

8. Procédé de fabrication selon l'une quelconque des revendications précédentes, comprenant en outre une étape de dépôt d'une électrode conductrice sur ladite deuxième couche (1).

9. Procédé de fabrication selon l'une quelconque des revendications précédentes, comprenant en outre une étape de dépôt d'une couche d'InGaN sur ladite première couche (2), la deuxième couche (1) étant déposée sur cette couche d'InGaN.

10. Procédé de fabrication selon l'une quelconque des revendications précédentes, dans lequel une pression partielle d'ammoniac au moins égale à 200Pa est maintenue dans l'enceinte pendant le retrait de la couche sacrificielle (21).

11. Procédé de fabrication selon l'une quelconque des revendications précédentes, dans lequel le retrait de la couche sacrificielle (21) est effectué avec une atmosphère dans l'enceinte comprenant du dihydrogène.

12. Procédé de fabrication selon l'une quelconque des revendications 1 à 10, dans lequel ledit retrait de la couche sacrificielle (21) est effectué avec une atmosphère dans l'enceinte qui contient du Cl₂ ou du HCl.

13. Procédé de fabrication selon l'une quelconque des revendications précédentes, dans lequel ladite étape de dépôt par épitaxie de la première couche (2) est précédée par une étape de saturation en ledit dopant d'une surface (3) sur laquelle la première couche (2) doit être déposée.

14. Procédé de fabrication selon l'une quelconque des revendications précédentes, dans lequel ladite étape de retrait de la couche sacrificielle (21) retire une épaisseur d'au moins 20 nm de cette couche sacrificielle.

15. Procédé de fabrication selon l'une quelconque des revendications précédentes, dans lequel ladite étape de retrait de la couche sacrificielle (21) est poursuivie jusqu'à découvrir ladite première couche (2).

## Patentansprüche

1. Herstellungsverfahren einer Elektrolumineszenzdiode (9), welches die Folge der folgenden Schritte umfasst, wobei ein Substrat (6) in einem Behälter für epitaktisches Wachstum in der Dampfphase gehalten wird:
- mit einer Atmosphäre in dem Behälter, die eine erste, von null verschiedene Konzentration von Ammoniak aufweist, epitaktische Abscheidung einer ersten Schicht (20) einer GaN-Legierung, die mit Magnesium p-dotiert ist;
- epitaktische Abscheidung, auf der ersten Schicht (20), einer Opferschicht (21) einer GaN-Legierung in einer Atmosphäre in dem Behälter, die nicht mit Magnesium gespeist wird;
- Versehen der Atmosphäre im Inneren des Behälters mit einer zweiten Konzentration von Ammoniak, die höchstens gleich einem Drittel der ersten Konzentration ist, um die Opferschicht (21) zu entfernen; danach
- epitaktische Abscheidung einer n-dotierten zweiten Schicht einer GaN-Legierung (1), um einen Tunnelübergang mit der ersten Schicht (2) zu bilden.

2. Herstellungsverfahren nach Anspruch 1, wobei die Legierung der abgeschiedenen ersten Schicht (2) AIGaN ist.

3. Herstellungsverfahren nach Anspruch 2, wobei die erste Schicht (2) einen Gradienten der Konzentration von Aluminium in ihrer Dicke aufweist.

4. Herstellungsverfahren nach einem der vorhergehenden Ansprüche, wobei die Dicke der abgeschiedenen ersten Schicht (2) zwischen 50 und 400 nm liegt.

5. Herstellungsverfahren nach einem der vorhergehenden Ansprüche, wobei die Legierung der Opferschicht (21) von der Legierung der ersten Schicht (20) verschieden ist.

6. Herstellungsverfahren nach einem der vorhergehenden Ansprüche, wobei die Legierung der abgeschiedenen zweiten Schicht (1) AIGaN ist.

7. Herstellungsverfahren nach einem der vorhergehenden Ansprüche, wobei das Substrat (6), das in dem Behälter für epitaktisches Wachstum gehalten wird, von einer Mehrfachquantentopfschicht (3) bedeckt wird, und wobei die erste Schicht (2) auf der Mehrfachquantentopfschicht (3) abgeschieden wird.

8. Herstellungsverfahren nach einem der vorhergehenden Ansprüche, welches außerdem einen Schritt der Abscheidung einer leitfähigen Elektrode auf der zweiten Schicht (1) umfasst.

9. Herstellungsverfahren nach einem der vorhergehenden Ansprüche, welches außerdem einen Schritt der Abscheidung einer Schicht von InGaN auf der ersten Schicht (2) umfasst, wobei die zweite Schicht (1) auf dieser Schicht von InGaN abgeschieden wird.

10. Herstellungsverfahren nach einem der vorhergehenden Ansprüche, wobei ein Partialdruck von Ammoniak, der wenigstens gleich 200 Pa ist, indem Behälter während der Entfernung der Opferschicht (21) aufrechterhalten wird.

11. Herstellungsverfahren nach einem der vorhergehenden Ansprüche, wobei die Entfernung der Opferschicht (21) mit einer Atmosphäre im Behälter durchgeführt wird, welche Diwasserstoff enthält.

12. Herstellungsverfahren nach einem der vorhergehenden Ansprüche, wobei die Entfernung der Opferschicht (21) mit einer Atmosphäre im Behälter durchgeführt wird, welche Cl₂ oder HCl enthält.

13. Herstellungsverfahren nach einem der vorhergehenden Ansprüche, wobei dem Schritt der epitaktischen Abscheidung der ersten Schicht (2) ein Schritt der Sättigung einer Oberfläche (3), auf welcher die erste Schicht (2) abgeschieden werden soll, mit dem Dotierstoff vorausgeht.

14. Herstellungsverfahren nach einem der vorhergehenden Ansprüche, wobei im Schritt der Entfernung der Opferschicht (21) eine Dicke von mindestens 20 nm dieser Opferschicht entfernt wird.

15. Herstellungsverfahren nach einem der vorhergehenden Ansprüche, wobei der Schritt der Entfernung der Opferschicht (21) fortgesetzt wird, bis die erste Schicht (2) freigelegt wird.

## Claims

1. Method for manufacturing a light-emitting diode (9), comprising the following steps in succession, while maintaining a substrate (6) in a vapour-phase epitaxial growth chamber:
- epitaxial deposition, with an atmosphere in the chamber having a first non-zero concentration of ammonia, of a first GaN alloy layer (20) P-doped with magnesium;
- epitaxial deposition, on the first layer (20), of a sacrificial GaN alloy layer (21) in an atmosphere in the chamber that is not supplied with magnesium;
- placing the atmosphere inside the chamber under conditions with a second concentration of ammonia that is at least equal to a third of the first concentration in such a way as to remove the sacrificial layer (21); then
- epitaxial deposition of a second N-type doped GaN alloy layer (1) in such a way as to form a tunnel junction with the first layer (2).

2. Manufacturing method according to Claim 1, wherein said alloy of the first deposited layer (2) is AIGaN.

3. Manufacturing method according to Claim 2, wherein the first layer (2) has an aluminium concentration gradient in the thickness thereof.

4. Manufacturing method according to any of the preceding claims, wherein the thickness of the first deposited layer (2) is between 50 and 400 nm.

5. Manufacturing method according to any of the preceding claims, wherein the alloy of the sacrificial layer (21) is different from the alloy of the first layer (20).

6. Manufacturing method according to any of the preceding claims, wherein said alloy of the second deposited layer (1) is AIGaN.

7. Manufacturing method according to any of the preceding claims, wherein said substrate (6) maintained in the epitaxial growth chamber is overlaid with a multiple quantum well layer (3) and wherein the first layer (2) is deposited on the multiple quantum well layer (3).

8. Manufacturing method according to any of the preceding claims, further comprising a step of depositing a conductive electrode on said second layer (1).

9. Manufacturing method according to any of the preceding claims, further comprising a step of depositing an InGaN layer on said first layer (2), the second layer (1) being deposited on said InGaN layer.

10. Manufacturing method according to any of the preceding claims, wherein a partial ammonia pressure at least equal to 200 Pa is maintained in the chamber during the removal of the sacrificial layer (21).

11. Manufacturing method according to any of the preceding claims, wherein the removal of the sacrificial layer (21) is carried out with an atmosphere in the chamber comprising dihydrogen.

12. Manufacturing method according to any of Claims 1 to 10, wherein said removal of the sacrificial layer (21) is carried out with an atmosphere in the chamber that contains Cl₂ or HCI.

13. Manufacturing method according to any of the preceding claims, wherein said step of epitaxial deposition of the first layer (2) is preceded by a step of saturation, in said dopant, of a surface (3) on which the first layer (2) must be deposited.

14. Manufacturing method according to any of the preceding claims, wherein said step of removing the sacrificial layer (21) removes a thickness of at least 20 nm from said sacrificial layer.

15. Manufacturing method according to any of the preceding claims, wherein said step of removing the sacrificial layer (21) is continued until said first layer (2) is revealed.
